# EUROPEAN PATENT SPECIFICATION

(11) **EP 0 549 842 B1**
(45) Date of publication and mention of the grant of the patent: **28.05.1997**
(21) Application number: 92100012.1
(22) Date of filing: 02.01.1992
(51) Int. Cl.: H04N 5/225, G01N 21/89, H01L 23/473

(54) **Camera unit for sheet surface flaw detection apparatus**
Kamera für Vorrichtung zur Erkennung von Oberflächenfehlern auf Materialbahnen
Caméra pour un appareil de détection de défauts de surface de feuille

(43) Date of publication of application: 07.07.1993
(73) Proprietor: FUTEC INCORPORATED, Takamatsu-shi Kagawa-ken (JP)
(72) Inventor: Mihara, Toshiro, Tokyo (JP)
(74) Representative: Lins, Edgar, Dipl.-Phys. Dr.jur.

(56) References cited:
- EP-A- 0 337 416
- DE-B- 2 819 395
- US-A- 4 136 377
- US-A- 4 724 481
- US-A- 5 068 715
- ELECTRONIC PACKAGING & PRODUCTION vol. 28, no. 4, April 1988, NEWTON, MASS., US pages 46 - 49 HOWARD W. MARKSTEIN 'Liquid Cooling Optimizes Heat Transfer'
- PATENT ABSTRACTS OF JAPAN vol. 13, no. 351 (P-912)7 August 1989 & JP-A-11 12 142
- PATENT ABSTRACTS OF JAPAN vol. 9, no. 162 (M-394)6 July 1985 & JP-A-60 034 878

## Description

The present invention relates to a camera unit used for photographing a sheet-like object in a flaw detection apparatus for the surface of the sheet-like object and, more particularly, to a camera unit, which employs a charge coupled device (CCD) linear array image sensor as a sensor camera, and is constituted by storing a plurality of such sensor cameras.

As an apparatus for detecting flaw dimensions (sheet widths, abnormal pitches of printed patterns, and the like) of respective portions of a sheet or a printed sheet as an example of an object to be inspected, or for detecting flaws (pinholes, foreign matters, contamination, black dots, fish eyes, printing offsets, changes in color, streak patterns, and the like) of the sheet or the printed sheet, a sheet surface flaw detection apparatus is known. The sheet surface flaw detection apparatus is disclosed in, e.g., U.S. Patent US-A-4,724,481 (February 9, 1988) to Nishioka, entitled "FLAW DETECTOR FOR DETECTING FLAWS IN A SHEET". A flaw detector disclosed in this patent photographs a sheet-like object using a plurality of CCD linear array cameras, which are aligned in the widthwise direction of the traveling sheet-like object, and processes the photographing signal so as to detect flaws.

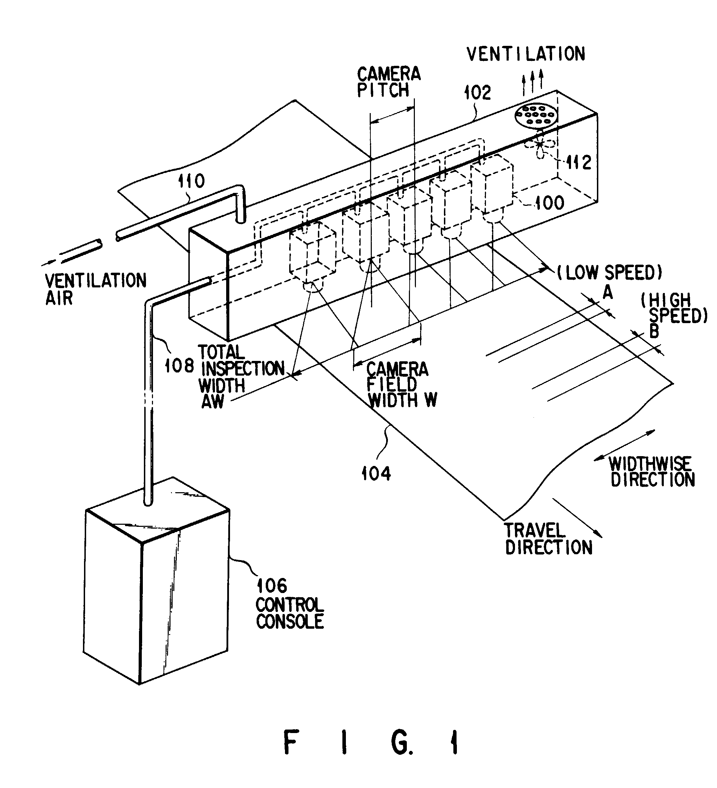

Although not particularly disclosed in the above-mentioned reference, in general, as shown in Fig. 1, a plurality of cameras 100 as described above are aligned and stored in a housing 102 extending in the widthwise direction of a sheet-like object 104, thus constituting a single camera unit. Video signals from the cameras 100 are input to a control console 106 through electrical wiring lines 108. In the control console 106, a signal processing circuit, as disclosed in the above-mentioned patent, is constituted, and can detect flaws. The detection results are output from a display device or a printing device (neither are shown) arranged in the control console 106.

In the flaw detection apparatus described above, the housing 102 of the camera unit is formed of a steel plate. As a method of cooling the camera unit, external air is blown from a ventilation pipe 110 to the housing 102 of the camera unit, or the camera unit is ventilated and cooled by a built-in ventilation fan 112 of the housing 102 of the camera unit.

In recent years, in order to meet a requirement for an increase in travel speed of the sheet-like object 104 as an object to be inspected, and to meet a requirement for detection of smaller flaws, a heat generating amount of the cameras 100 assembled in the housing 102 of the camera unit tends to be increased, or the number of cameras to be assembled is increased, and as a result, a thermal load on the housing 102 of the camera unit tends to be increased. More specifically, the production line of the sheet-like object 104 as an object to be inspected tends to be driven at higher speed so as to improve productivity. In addition, flaws to be detected tend to become smaller.

Such tendencies for a camera using a CCD linear array image sensor as a sensor lead to an increase in heat generating amount for the following reasons.
(A) A length range of a sheet member, which crosses a field of view of the cameras 100 in a predetermined period of time, corresponds to a range A in Fig. 1 at a low speed, while it is prolonged, as represented by a range B in Fig. 1, as the driving speed of the sheet-like object 104 to be detected is increased. In order to obtain a resolution equivalent to that at a low speed, an accumulation time (scan rate) of the cameras 100 must be shortened. This leads to a requirement for an increase in speed of camera driving clocks, and results in an increase in power consumption of an electronic circuit, in other words, an increase in heat generation amount.
(B) When flaws to be detected become smaller, a field width W per camera is narrowed. Therefore, in order to assure a field width (total field width AW), which can cover the total width of the sheet-like object to be inspected, the number of cameras must be increased. More specifically, the density of cameras 100 per unit length (per unit length in the direction of width to be inspected) is increased. As a result, a thermal load on the camera unit is increased.

In general, the service life of an electronic circuit depends on the temperature of circuit elements. More specifically, as the temperature is increased in a large power consumption state, the service life becomes shorter. The service life of capacitors as typical elements of an electronic circuit is particularly influenced by the temperature. The CCD linear array image sensor has a specific thermal noise signal. The thermal noise signal is increased as the temperature of the CCD is increased.

Therefore, heat generation in the camera unit must be prevented or the interior of the camera unit must be cooled by some method. As the conventional method adopted in the camera unit, external air is blown from the ventilation pipe 110 into the camera unit, or the interior of the camera unit is ventilated by the fan 112.

Normally, when external air is blown, compressor air (compressed air) is used. The compressor air normally contains a small amount of oil. The oil becomes attached to glass portions such as lenses of the cameras 100, and impairs the camera performance over a long period of time. The oil also becomes attached to a window glass portion formed at a given position of the housing 102 of the camera unit in correspondence with the lens of each camera 100, thus increasing the cleaning maintenance frequency. When the cleaning maintenance is impossible in terms of space, the performance of the camera unit is permanently impaired.

When ventilation by the fan 112 is adopted, it is difficult to perfectly prevent entrance of dust in external air or a small amount of oil.

The present invention has been made in consideration of the above situation, and has as its objects to improve a heat radiation performance, thereby (A) realizing a high-density arrangement of cameras, (B) prolonging the service life of cameras and improving reliability, (C) preventing contamination in the camera unit, and (D) reducing thermal noise of a camera signal.

According to the present invention, there is provided a camera unit as in claim 1.

Further details of the present invention are set out in the dependent claims.

More specifically, a housing of a camera unit is integrated with a radiator, and is formed of an extruded member or a drawn member of a copper alloy or an aluminum alloy. The heat radiation performance can be improved four to eight times that of a conventional housing formed of a steel plate. More specifically, the heat radiation performance of a metal is proportional to its thermal conductivity. The thermal conductivities of steel, an aluminum alloy, and copper are, respectively, about 50, 236, and 403 W·m⁻¹·°K⁻¹, and the ratios of improvement of the heat radiation performance are 236/50 and 403/50, i.e., about four to eight times.

As a result, the improved heat radiation performance can realize a camera arrangement, which allows a package length of a CCD linear array image sensor as a camera aligning pitch at the theoretically highest density to correspond to an actual camera aligning pitch.

This invention can be more fully understood from the following detailed description when taken in conjunction with the accompanying drawings, in which:
Fig. 1 is a perspective view showing an arrangement of a sheet surface flaw detection apparatus to which a conventional camera unit is applied;
Figs. 2A and 2B are respectively a sectional view and a plan view showing an arrangement of a camera unit according to an embodiment of the present invention; and
Figs. 3A and 3B are respectively a sectional view, corresponding to Fig. 2A, showing the positional relationship among a plurality of CCD linear array image sensors in the camera unit according to the embodiment of the present invention, and a sectional view taken along a line A - A in Fig. 3A.

An embodiment of the present invention will be described below with reference to the accompanying drawings.

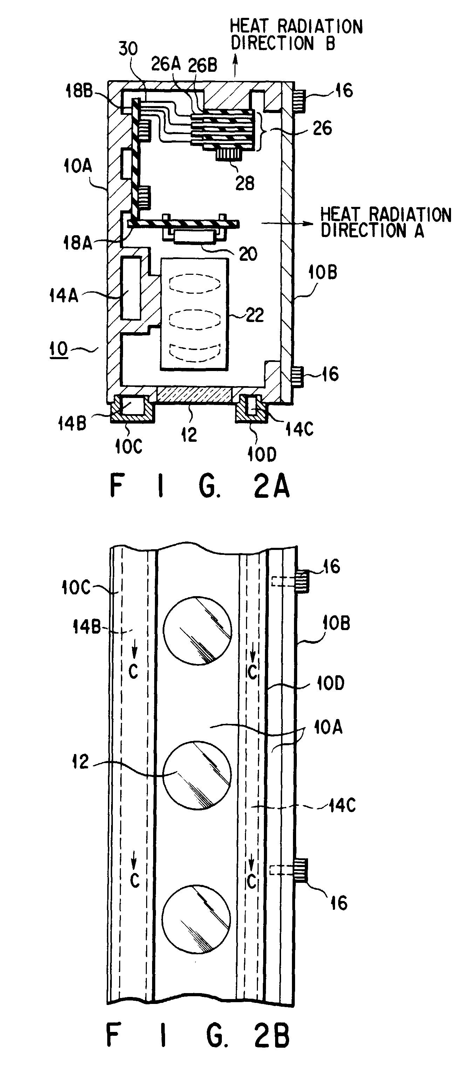

Fig. 2A is a sectional view of a camera unit according to an embodiment wherein the present invention is applied to, e.g., a sheet surface flaw detection apparatus. In this embodiment, a housing 10 is constituted by four different extruded members 10A, 10B, 10C, and 10D.

The first extruded member 10A has a substantially U-shaped section, and its longitudinal direction extends in the widthwise direction of a traveling sheet-like object to be inspected (not shown). Windows are formed at given positions on the surface, opposing the sheet-like object to be inspected, of the first extruded member 10A in correspondence with sensor cameras stored in a camera unit. Window glasses 12 are fitted in these windows.

A first flow path 14A extending in the longitudinal direction of the first extruded member 10A is formed on the inner surface of the member 10A. The flow path 14A is an independent fluid flow path arranged inside the camera unit, and a cooling medium flowing through the flow path 14A can cool the interior of the camera unit. As the cooling medium, water is effective since it has a large specific heat. However, an oil or air may be adopted, as a matter of course.

The second extruded member 10B is a lid attached to the open side of the first extruded member 10A by fixing screws 16. The second extruded member 10B has a role of closing the interior of the camera unit as a closed space, and also has a role of radiating heat in a direction of an arrow A in Fig. 2A.

The third and fourth extruded members 10C and 10D extend in the longitudinal direction of the camera unit, and are attached on the two sides of the window glasses 12 to sandwich them therebetween, thus respectively forming second and third flow paths 14B and 14C. These second and third flow paths 14B and 14C are independent fluid flow paths arranged on the outer surface of the camera unit. As a cooling medium flowing through the corresponding flow path in a direction of an arrow C in Fig. 2B, water is preferable. However, an oil or air may be adopted like in the first flow path 14A. The cooling effects of the two flow paths 14B and 14C include an effect of absorbing heat generated from the interior of the camera unit, an effect of shielding thermal radiation from a sheet medium to be inspected when the sheet medium to be inspected is at a high temperature, and an effect of thermally cooling and protecting the camera unit from a high-temperature atmosphere near the window glasses 12.

A plurality of circuit boards 18A on which CCD linear array image sensors 20 are mounted, a plurality of circuit boards 18B on which drivers for the CCD linear array image sensors 20, and the like are formed, the plurality of CCD linear array image sensors 20, and a plurality of optical systems 22, each of which is constituted by a plurality of lenses arranged between each CCD linear array image sensor 20 and the corresponding window glass 12, are arranged in the first extruded member 10A. Electronic members 24 such as ICs, transistors, capacitors, resistors, and the like are mounted on each circuit board 18B. The circuit boards 18B are fixed to the first extruded member 10A by screws.

Furthermore, a bus line 26 is mounted on the first extruded member 10A by fixing screws 28. The bus line 26 is constituted by four copper plates 26A extending in the longitudinal direction of the camera unit, and five electrical insulating plates 26B for insulating the copper plates 26A from each other. The copper plates 26A are connected to the circuit boards 18B arranged in units of cameras through connection wires 30. The four copper plates 26A are electrically insulated from each other by the insulating plates 26B arranged there-between. The four copper plates 26A include three copper plates for supplying a power supply voltage to the circuits such as drivers formed on the circuit board 18B and to the CCD linear array image sensor 20, and a copper plate for supplying start pulses for driving the CCD linear array image sensors 20.

The bus line 26 is fixed to the first extruded member 10A by screws through a thin electrical insulating plate (normally, 0.18 mm thick). Heat generated by a current flowing through the bus line 26 can be efficiently radiated externally (in a direction of an arrow B in Fig. 2A) through the thin insulating plate and the extruded member 10A.

The power supply voltage and the start pulses are applied onto the bus line 26 from a control console (not shown) through electrical wiring lines (not shown). Video signals from the CCD linear array image sensors 20 are supplied to a signal processing circuit arranged in the control console (not shown) through the electrical wiring lines (not shown), thereby detecting flaws. Since the signal processing circuit is disclosed in detail in U.S. Patent US-A-4,724,481, a detailed description thereof will be omitted here.

As the material of the camera unit housing 10, i.e., that of the first to fourth extruded members 10A to 10D, copper is best in terms of heat radiation performance. However, in terms of cost, aluminum or an aluminum alloy is the second best means.

More specifically, the heat radiation performance of a metal is proportional to its thermal conductivity. The thermal conductivities of steel, an aluminum alloy, and copper are, respectively, about 50, 236, and 403 W·m⁻¹·°K⁻¹, and the ratios of improvement of the radiation performance are 236/50 and 403/50, i.e., about four to eight times. Therefore, the heat radiation performance can be improved four to eight times that of a conventional housing formed of a steel plate. The improved heat radiation performance can realize a camera arrangement, which allows a package length of the CCD linear array image sensors 20 as a camera aligning pitch at the theoretically highest density to correspond to an actual camera aligning pitch.

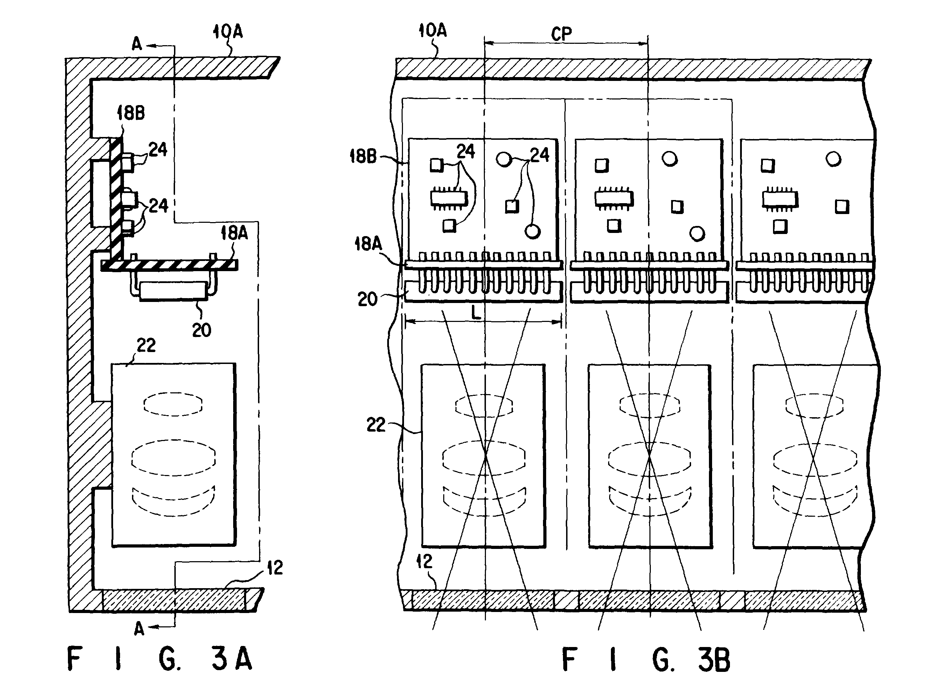

More specifically, in Fig. 3B, since the heat radiation performance of the camera unit housing 10 can be improved, a camera pitch CP can be shortened to a package length L of the CCD linear array image sensors 20. In this case, the dimensions of the circuit boards (18A and 18B), and the diameters of the lenses (the optical systems 22) can be set to be smaller than the package length L of the CCD linear array image sensors 20. In this embodiment, partition walls (i.e., a housing of each camera (indicated by alternate long and two short dashed line in Fig. 3B)) between adjacent cameras is omitted to further improve the heat radiation performance, and to shorten the camera pitch.

As a manufacturing method of the housing, a drawing method is preferable in terms of dimensional precision. However, an extrusion method is the second best means in terms of cost.

Although not shown, the end portion of the camera unit housing 10 (the end portion in the widthwise direction of the sheet medium) corresponds to a light thermal load portion, and its structure and material may be arbitrarily selected.

In this embodiment, the independent flow paths 14A, 14B, and 14C for a cooling fluid, which paths are formed of an extruded member of a copper alloy or an aluminum alloy, are arranged on the inner or outer surface of the camera unit housing. Thus, the interior of the camera unit can be defined as a closed space shielded from external air. Therefore, the optical members can be prevented from being contaminated with a small amount of oil contained in the cooling fluid.

In order to further improve the heat radiation performance, the metal housings of the respective cameras are omitted, and the bus line 26 for supplying a power supply voltage and start pulses is arranged to be in tight contact with the camera unit housing 10. Thus, heat generated by the bus line 26 can be efficiently externally radiated through the camera unit housing 10.

The embodiment of the present invention has been described. However, the present invention is not limited to a flaw detection apparatus for detecting flaws in a traveling sheet medium. For example, the present invention may be applied to an apparatus for detecting flaws in a still sheet medium (i.e., a glass plate, a paper sheet surface, a sheet glass plate, and the like) as long as a camera unit is moved. More specifically, the present invention can be applied to both cases wherein one or both of the sheet medium and the camera unit are movable. Furthermore, the present invention can be applied to any other apparatuses, which utilize a camera unit constituted by aligning a plurality of cameras in a single housing in addition to the flaw detection apparatus.

As described above, according to the present invention, the heat radiation performance of the camera unit storing the plurality of cameras is improved, so that detection performance (corresponding to a high-speed sheet and small flaws), reliability, and the service life can be improved, thus providing great industrial advantages.

## Claims

1. A camera unit wherein a plurality of cameras are stored in an array in a housing, said cameras comprising charge coupled device (CCD) linear array image sensors, and optical systems for forming images on the corresponding CCD linear array image sensors,
wherein windows are formed in said housing at positions opposing said CCD linear array image sensors to sandwich said optical systems therebetween, and transparent window glasses are fitted in the windows, characterized in that
a principal structure of said housing (10) is formed of a material selected from the group including copper, a copper alloy, aluminum, and an aluminum alloy, by one of an extrusion method and a drawing method, and a camera mounting pitch (CP) of said plurality of cameras stored in an array in said housing (10) is substantially equal to an integrated circuit (IC) package length (L)
CCD linear array image sensors (20).

2. The camera unit according to claim 1, characterized by further comprising:
an independent cooling fluid flow path (14A, 14B, 14C), arranged on at least one of inner and outer surfaces of said housing (10), for flowing a cooling medium therethrough.

3. The camera unit according to claim 1, characterized by further comprising:
a bus line structure (26), arranged to be in tight contact with a inner surface of said housing (10), for supplying a power supply voltage and a start signal to said cameras.

4. The camera unit according to claim 2, characterized in that said flow path (14A, 14B, 14C) is formed of a material selected from the group including copper alloy, aluminum, and an aluminum alloy, by one of the extrusion method and the drawing method.

5. The camera unit according to claim 2 or 4, characterized in that said flow path (14B, 14C) arranged on the outer surface of said housing (10) is arranged near said window glasses.

6. The camera unit according to claim 3, characterized in that said bus line structure (26) is mounted on said housing (10) through an insulating plate (26B).

7. The camera unit according to claim 6, characterized in that said bus line structure (26) comprises a plurality of copper plates (26A) extending in a longitudinal direction of said camera unit, and sandwiching insulating plates (26B) therebetween.

## Patentansprüche

1. Kamera-Einheit mit einer Anordnung (array) einer Vielzahl von Einzelkameras in einem Gehäuse, wobei die Kameras CCD-Bildaufnehmer mit ladungsgekoppelten Speichereinheiten (CCD) in linearer Anordnung aufweisen, sowie optische Systeme zum Projizieren von Bildern auf die entsprechenden CCD-Bildaufnehmer,
wobei in dem Gehäuse Fenster an Stellen ausgeformt sind, die den CCD-Bildaufnehmern gegenüberliegen, und die optischen Systeme zwischen sich aufnehmen, und durchsichtige Fenstergläser in den Fenstern angeordnet sind, dadurch gekennzeichnet, daß
ein Grundkörper des Gehäuses (10) aus einem der folgenden Materialien besteht: Kupfer, eine Kupferlegierung, Aluminium oder eine Aluminiumlegierung, und entweder durch Strangpressen (Extrudieren) oder durch Ziehen hergestellt ist, und
die Kamera-Abstände (Teilung CP) der in dem Gehäuse (10) angeordneten Kameras im wesentlichen der Gehäuselänge (L) eines integrierten Schaltkreises (IC) der CCD-Bildaufnehmer (20) entspricht.

2. Kamera-Einheit nach Anspruch 1, dadurch gekennzeichnet, daß zumindest ein unabhängiger Strömungsweg (14A, 14B, 14C) für eine Kühlflüssigkeit auf entweder der inneren oder äußeren Oberfläche des Gehäuses (10) angeordnet ist, um eine Kühlflüssigkeit hindurchströmen zu lassen.

3. Kamera-Einheit nach Anspruch 1, dadurch gekennzeichnet, daß eine Busleitung (26) in engem Kontakt mit der inneren Oberfläche des Gehäuses (10) angeordnet ist, um eine Versorgungsspannung und ein Startsignal zu den Kameras zu liefern.

4. Kamera-Einheit nach Anspruch 2, dadurch gekennzeichnet, daß der Strömungsweg (14A, 14B, 14C) aus einem der folgenden Materialien gebildet ist: eine Kupferlegierung, Aluminium, oder eine Aluminiumlegierung, entweder durch Strangpressen (Extrudieren) oder durch Ziehen.

5. Kamera-Einheit nach Anspruch 2 oder 4, dadurch gekennzeichnet, daß der Strömungsweg (14B, 14C) auf der äußeren Oberfläche des Gehäuses in der Nähe der Fenstergläser angeordnet ist.

6. Kamera-Einheit nach Anspruch 3, dadurch gekennzeichnet, daß die Busleitung (26) an dem Gehäuse (10) mittels einer Platte (26B) aus einem isolierenden Material angeordnet ist.

7. Kamera-Einheit nach Anspruch 6, dadurch gekennzeichnet, daß die Busleitung (26) eine Vielzahl von Kupferplatten (26A) aufweist, die sich in Längsrichtung der Kamera-Einheit mit zwischengeordneten Isolierplatten (26B) erstrecken.

## Revendications

1. Unité de caméra dans laquelle une pluralité de caméras sont installées en alignement dans un logement, lesdites caméras comprenant des capteurs d'images colinéaires à circuits de transfert de charges (CCD), et des systèmes optiques pour former des images sur les capteurs d'images colinéaires à CCD correspondants,
dans laquelle des fenêtres sont formées dans ledit logement à des positions en face desdits capteurs d'images colinéaires à CCD pour prendre en sandwich entre elles lesdits systèmes optiques, et dans laquelle des vitres transparentes sont mises en place dans les fenêtres, caractérisée par le fait
qu'une structure principale dudit logement (10) est formée d'un matériau sélectionné dans le groupe incluant le cuivre, un alliage de cuivre, l'aluminium et un alliage d'aluminium, par une méthode d'extrusion ou une méthode d'étirage, et par le fait qu'un pas de montage de caméra (CP) de ladite pluralité de caméras installées en alignement dans ledit logement (10) est substantiellement égal à la longueur (L) d'un boîtier de circuit intégré (IC) des capteurs d'images colinéaires à CCD (20).

2. Unité de caméra selon la revendication 1, caractérisée en outre par le fait qu'elle comprend :
un chemin d'écoulement de fluide de refroidissement indépendant (14A, 14B, 14C), arrangé sur au moins l'une des surfaces interne et externe dudit logement (10), pour faire passer un milieu de refroidissement à travers lui.

3. Unité de caméra selon la revendication 1, caractérisée en outre par le fait qu'elle comprend :
une structure de ligne de bus (26), arrangée de manière à être en contact étroit avec une surface interne dudit logement (10), pour fournir une tension d'alimentation de puissance et un signal de mise en marche auxdites caméras.

4. Unité de caméra selon la revendication 2, caractérisée par le fait que ledit chemin d'écoulement (14A, 14B, 14C) est formé d'un matériau sélectionné dans le groupe incluant un alliage de cuivre, l'aluminium, et un alliage d'aluminium, par une méthode d'extrusion ou une méthode d'étirage.

5. Unité de caméra selon la revendication 2 ou 4, caractérisée par le fait que ledit chemin d'écoulement (14B, 14C) arrangé sur la surface externe dudit logement (10) est arrangé près desdites vitres.

6. Unité de caméra selon la revendication 3, caractérisée par le fait que ladite structure de ligne de bus (26) est montée sur ledit logement (10) à travers une plaquette isolante (26B).

7. Unité de caméra selon la revendication 6, caractérisée par le fait que ladite structure de ligne de bus (26) comprend une pluralité de plaquettes de cuivre (26A) s'étendant dans une direction longitudinale de ladite unité de caméra, et prenant en sandwich les plaquettes isolantes (26B) entre elles.
